(19) **Europäisches Patentamt / European Patent Office / Office européen des brevets**

(11) **EP 2 598 896 B1**

(12) # FASCICULE DE BREVET EUROPEEN

(45) Date de publication et mention de la délivrance du brevet:
**29.10.2014 Bulletin 2014/44**

(21) Numéro de dépôt: **11755380.0**

(22) Date de dépôt: **28.07.2011**

(51) Int Cl.:
*G01R 15/20* ^(2006.01)        *H01M 10/48* ^(2006.01)
*H01M 8/04* ^(2006.01)

(86) Numéro de dépôt international:
**PCT/FR2011/051825**

(87) Numéro de publication internationale:
**WO 2012/013906 (02.02.2012 Gazette 2012/05)**

(54) **CAPTEUR INTEGRE DE MESURE DE TENSION OU DE COURANT A BASE DE MAGNETORESISTANCES**

MAGNETORESISTOR-INTEGRIERTER SENSOR ZUR SPANNUNGS- ODER STROMMESSUNG UND DIAGNOSESYSTEM

MAGNETORESISTOR INTEGRATED SENSOR FOR MEASURING VOLTAGE OR CURRENT, AND DIAGNOSTIC SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.07.2010 FR 1056332**
                **30.07.2010 FR 1056329**

(43) Date de publication de la demande:
**05.06.2013 Bulletin 2013/23**

(73) Titulaires:
• **Commissariat à l'Énergie Atomique et aux Énergies Alternatives**
  **75015 Paris (FR)**
• **PSA Peugeot Citroen Automobiles S.A.**
  **78140 Velizy Villacoublay (FR)**

(72) Inventeurs:
• **PANNETIER-LECOEUR, Myriam**
  **F-91440 Bures sur Yvette (FR)**

• **FERMON, Claude**
  **F-91400 Orsay (FR)**
• **GIRAUD, Alain**
  **F-91400 Orsay (FR)**
• **ROY, Francis**
  **F-91940 Les Ulis (FR)**

(74) Mandataire: **Ménès, Catherine**
  **Peugeot Citroën Automobiles SA**
  **Propriété Industrielle (LG081)**
  **18, rue des Fauvelles**
  **92250 La Garenne Colombes (FR)**

(56) Documents cités:
  **WO-A1-2006/136577      DE-A1- 10 113 131**
  **US-A1- 2004 155 644    US-A1- 2005 110 464**
  **US-A1- 2006 061 350    US-A1- 2009 237 085**

## Description

Domaine de l'invention

La présente invention concerne un capteur intégré de mesure de tension via un courant ou de mesure de courant à base de magnétorésistances, telles que des magnétorésistances géantes ou des magnétorésistances tunnel présentant une isolation galvanique importante, le capteur comprenant des première et deuxième bornes de connexion à un générateur dont la tension ou le courant est à mesurer, reliées à une ligne de mesure métallique dans laquelle circule un courant proportionnel à la tension ou au courant du générateur qui est à mesurer, ledit courant circulant dans cette ligne créant un champ magnétique mesuré à distance par les magnétorésistances.

La présente invention concerne également un système de diagnostic de mesure de tension ou de courant d'un générateur électrique pouvant notamment être embarqué dans un véhicule pour une application dynamique ou disposé dans une installation statique de production d'électricité et pouvant comporter une pluralité de cellules.

L'invention s'applique notamment à la mesure de tension de générateurs électriques embarqués comportant une pluralité de cellules élémentaires, telles les piles à combustible pour des applications automobiles.

Le domaine auquel se rapporte cette invention est celui de systèmes électroniques embarqués pour la lecture, le traitement et la transmission de la mesure d'une pluralité de sources de tension délivrée dans un contexte environnemental sévère. Entre autres les exigences réglementaires et sécuritaires au vu d'une application automobile imposent une isolation galvanique de l'ordre de 1500V entre l'unité de mesure et la source à mesurer, le niveau d'isolation galvanique étant plus généralement défini par 2*U + 1000V RMS où U est la tension maximum de fonctionnement.

Art antérieur de référence

Ce besoin technologique de mesure d'une pluralité de tensions a déjà été mis en évidence dans le document de brevet FR 2 934 419 AI. La solution technologique présentée dans ce document de l'art antérieur est basée sur un principe de conversion tension/fréquence et la transmission d'un signal binarisé au travers d'optocoupleurs assurant l'isolation galvanique demandée. Toutefois, ce type de dispositif nécessite une alimentation spécifique pour assurer la mesure. Selon ce document, l'énergie est ainsi directement puisée sur les plaques bipolaires de la pile à combustible alimentées en hydrogène et en oxygène.

On connaît par ailleurs différents systèmes dans lesquels des mesures de tensions sont effectuées à l'aide de dispositifs intrusifs qui sont utilisés pendant les phases de mise au point des piles à combustible.

Dans ce cas, aucune alimentation embarquée, ni module de mesure, ne sont nécessaires, puisque de tels dispositifs ne restent pas à demeure dans le véhicule, mais ces dispositifs de mesure ne permettent pas d'effectuer un diagnostic permanent interagissant avec le contrôle/commande du système pile à combustible par exemple. Par ailleurs, pour les piles disposant d'un grand nombre de cellules, cela signifie la présence d'ombilicaux assez contraignants pour l'environnement même de la pile et l'utilisation de boîtiers intermédiaires ou de cartes d'acquisition complexes, commerciales ou dédiées, maintenant une isolation correcte entre la pile et le banc de mesures.

Pour les systèmes restant à demeure dans le véhicule, on connaît l'utilisation d'un système électronique embarqué utilisant principalement un convertisseur analogique-numérique et un microcontrôleur associé pour lire, établir éventuellement un diagnostic et transmettre la donnée numérisée. En général, l'isolation galvanique est maîtrisée (> 1500V). Le système est alimenté par un convertisseur continu/continu à partir de la batterie ou de toute source de tension externe et la transmission de la donnée passe par un convertisseur optoélectronique. Ce système composé d'un convertisseur et d'un microcontrôleur permet de lire plusieurs cellules multiplexées sur le ou les canaux du convertisseur, référencés à un même potentiel. Cette lecture peut être directe lorsque la pile n'est formée que d'un petit nombre de cellules, et tant que la tension de la dernière cellule reste compatible avec la tension fournie par le convertisseur continu/continu. Ce n'est plus le cas lorsque le nombre de cellules devient important. On doit alors ramener par pont de résistances les tensions des différentes cellules à des niveaux compatibles avec les caractéristiques du convertisseur et gérer de nombreux multiplexeurs avec le risque inhérent à l'acheminement d'un grand nombre d'informations (présence de nombreux potentiels dans le routage, diaphonie, précision, commutations, ...).

On connaît encore l'utilisation de plusieurs convertisseurs continu/continu à partir d'une source externe à la pile (batterie, alimentation, ...) afin de fournir plusieurs sources d'alimentation de systèmes de diagnostic autonomes gérés en parallèle. Cette méthode permet de disposer de plusieurs référentiels et de regrouper les cellules en paquets associés chacun à un convertisseur et un microcontrôleur. De tels systèmes sont fortement pénalisés par l'encombrement et par la complexité du traitement des informations.

Les systèmes susmentionnés ne donnent pas entière satisfaction lorsque l'on vise des applications où les contraintes d'encombrement et de fiabilité deviennent prépondérantes, comme dans le cas d'une application au domaine automobile qui implique notamment les contraintes suivantes:

- Encombrement réduit,

- Dissipation thermique des différents modules,

- Précision de la mesure des tensions de chaque cellule qui peut être affectée par la présence des ponts diviseurs et des commutateurs utilisés pour mesurer des tensions parfois faibles et fluctuantes,

- Fiabilité de la mesure durant toute la vie du véhicule, malgré le vieillissement des composants,

- Compatibilité des principes de mesures et de conditionnements des données avec le réseau CAN (« Controller Area Network ») du véhicule.

Par ailleurs, le développement de capteurs magnétorésistifs à base de magnétorésistances géantes (GMR) ou de magnétorésistances tunnel (TMR) fait l'objet d'intenses développements au niveau mondial. La première application est les têtes de lecture de disques durs qui sont maintenant fabriquées à l'aide de cette technologie. Les autres applications sont plus récentes et couvrent surtout des capteurs de position ou d'angle.

La société NVE (www.nve.com) a lancé récemment la commercialisation d'un capteur de courant constitué d'un pont de GMR et d'une ligne de courant.

On peut aussi citer en référence la publication Pannetier-Lecoeur, M; Fermon, C; de Vismes, A, et al., JOURNAL OF MAGNETISM AND MAGNETIC MATERIALS Vol 316 Pages: E246-E248 (2007) qui décrit un capteur de courant à base de GMR.

Les magnétorésistances tunnel (TMR) présentent une plus grande sensibilité que les magnétorésistances géantes (GMR) mais aussi un bruit plus important et une fabrication plus difficile. Elles peuvent être avantageusement utilisées dans le cas où les températures de fonctionnement doivent dépasser les 180°c.

On peut également citer le document US 2005/0110464 qui décrit un système pour surveiller une pluralité de tensions de pile d'un dispositif électrochimique pour une pluralité de cellules connectées en série, le système comprenant une pluralité de broches de connexion agencées pour être amovible relatif à la pluralité de cellules, une pluralité d'amplificateurs différentiels, chaque amplificateur différentiel ayant une pluralité de résistances découpées par laser fournissant correspondance, de sorte que les signaux en mode commun sont rejetés, alors que les signaux d'entrée différentiels sont amplifiés.

Le document WO2006/136577 A1 décrit un capteur intégré de mesure de tension via un courant ou de mesure de courant à base de magnétorésistances, comprenant des première et deuxième bornes de connexion à un générateur dont la tension ou le courant est à mesurer, reliées à une ligne de mesure métallique dans laquelle circule un courant proportionnel à la tension ou au courant du générateur qui est à mesurer, et au moins deux magnétorésistances de mesure du champ magnétique créé à distance par le courant circulant dans la ligne de mesure.

Objet et description succincte de l'invention

La présente invention vise à remédier aux inconvénients précités et à permettre de disposer d'un capteur intégré avec une isolation galvanique importante, qui permette des mesures de tension ou de courant pour des générateurs embarqués et autorise une mise en oeuvre compacte et fiable.

Ces buts sont atteints, conformément à l'invention, grâce à un capteur intégré de mesure de tension via un courant ou de mesure de courant à base de magnétorésistances, comprenant des première et deuxième bornes de connexion à un générateur dont la tension ou le courant est à mesurer, reliées à une ligne de mesure métallique dans laquelle circule un courant proportionnel à la tension ou au courant du générateur qui est à mesurer, et au moins deux magnétorésistances de mesure du champ magnétique créé à distance par ledit courant circulant dans ladite ligne de mesure, caractérisé en ce que la ligne de mesure métallique comprend au moins des premier et deuxième tronçons allongés et parallèles dans lesquels le courant circule en sens opposés, reliés à une portion destinée à fermer la ligne de mesure, l'ensemble de la ligne de mesure métallique étant disposée sur l'une des faces d'une couche d'isolation galvanique intégrée pour des tensions supérieures ou égales à 1500 V, ladite couche d'isolation galvanique intégrée étant elle-même disposée sur une portion de circuit intégré de détection, ladite portion de circuit intégré de détection comprenant lesdites au moins deux magnétorésistances qui présentent elles-mêmes chacune une partie sensible qui est essentiellement superposée à l'un des tronçons allongés de la ligne de mesure métallique afin d'être sensible au champ créé par le courant circulant dans la ligne de mesure et en ce que chacun des premier et deuxième tronçons allongés de la ligne de mesure métallique comprend un rétrécissement dans une zone voisine d'une zone superposée à une piste de liaison à un contact de masse, du côté desdites première et deuxième bornes, lesdits rétrécissements servant de fusible intégré en cas de défaut d'isolation créé par un pic de surtension.

Avantageusement, l'ensemble de la ligne de mesure métallique est directement déposé sur l'une des faces de la couche d'isolation galvanique intégrée, et en vis-à-vis avec la partie sensible des magnétorésistances déposées directement sur l'autre face de cette couche d'isolation galvanique intégrée, de sorte que seule l'épaisseur de cette couche d'isolation sépare la ligne de mesure de l'élément sensible.

Les magnétorésistances peuvent être des magnétorésistances géantes ou des magnétorésistances tunnel.

De préférence, ladite portion de circuit intégré de détection comprend un pont de magnétorésistances et des pistes de liaison à au moins un contact de polarisation en tension Vcc, un contact de masse et des contacts de pôles négatif Vin- et positif Vin+ d'une tension différentielle de sortie.

Avantageusement, les magnétorésistances présentent chacune la forme d'un C avec une branche centrale longitudinale qui constitue ladite partie sensible qui est essentiellement superposée à l'un des tronçons allongés de la ligne de mesure métallique afin d'être sensible au champ créé par le courant circulant dans la ligne de mesure.

Avantageusement, dans le cas de magnétorésistances géantes, chacune des magnétorésistances géantes présente une longueur comprise entre 100 et 500 micromètres et une largeur comprise entre 2 et 8 micromètres.

Avantageusement, dans le cas de magnétorésistances tunnel, chacune des magnétorésistances tunnel présente une couche libre en forme de C de longueur comprise entre 40 et $150 \mu m$ et une largeur comprise entre 2 et $8 \mu m$ et une couche dure formée d'un ou de deux plots dont la taille est ajustée pour obtenir des résistances comprises entre 300 ohms et 10 kiloohms.

De préférence, la ligne de mesure métallique présente une résistance comprise entre 30 et 100 ohms, ce qui est adapté à des courants de l'ordre de 5 à 100 mA compte tenu des tensions habituelles à mesurer.

Enfin la configuration particulière des capteurs et des lignes de courant permet d'envisager une fonction fusible intégrée qui fait qu'en cas de surtension trop importante ou de décharge électrostatique dépassant un seuil ajustable, la ligne de courant intégrée peut servir de fusible instantané. Pour cela, chacun des premier et deuxième tronçons allongés de la ligne de mesure métallique de chaque capteur de mesure de tension ou de courant comprend un rétrécissement dans une zone voisine d'une zone superposée à la piste de liaison au contact de masse, du côté desdites première et deuxième bornes, lesdits rétrécissements servant de fusible intégré en cas de défaut d'isolation créé par un pic de surtension.

Selon une caractéristique préférentielle de l'invention, les premier et deuxième tronçons allongés de la ligne de mesure métallique présentent une largeur comparable à celle desdites parties sensibles des magnétorésistances.

Selon un autre aspect de l'invention, la couche d'isolation galvanique est plane et présente une épaisseur comprise entre 5 et 15 micromètres, l'épaisseur étant reliée à l'isolation galvanique souhaitée et la nature du matériau isolant choisi.

Selon un mode particulier de réalisation possible, la couche d'isolation galvanique est constituée par un dépôt de résine durcie.

Dans ce cas, la couche d'isolation galvanique peut comprendre un polyimide ou du bisbenzocyclotène (BCB).

Selon un autre mode particulier de réalisation, la couche d'isolation galvanique est constituée par un dépôt d'isolant céramique.

Dans ce cas, la couche d'isolation galvanique peut comprendre une couche de $Si_3N_4$ ou de $Al_2O_3$.

Le capteur intégré selon l'invention peut être appliqué à la mesure de la tension ou du courant d'un générateur constitué par une pile à combustible présentant une tension de sortie comprise entre 0 et 1,3 V.

Le contact de polarisation en tension Vcc et le contact de masse peuvent être reliés à une batterie d'alimentation électrique présentant une tension comprise entre 1 et 12V. La résistance des GMR sera alors choisie de telle façon que le courant circulant dans celles-ci ne dépasse pas 1mA par $\mu m$ de largeur des GMR. Dans le cas des TMR, la polarisation de tension doit être choisie pour obtenir environ 0,4V sur chaque plot de la TMR.

L'invention proposée permet ainsi de résoudre plusieurs problèmes importants non résolus dans les travaux de l'art antérieur.

Ainsi, la présente invention permet d'avoir une isolation galvanique importante entre la ligne de courant et le pont de magnétorésistances tout en définissant un capteur totalement intégré. Alors que des distances de l'ordre du mm sont en général utilisées, la technologie proposée permet d'avoir les lignes de courant situées typiquement à $8 \mu m$ du pont de GMR.

La taille et la conformation du pont de magnétorésistances choisi permettent d'obtenir des linéarités compatibles avec les spécifications nécessaires pour l'application visée.

L'utilisation en complément d'un champ de polarisation longitudinal permet d'améliorer encore cette linéarité. Cette technique a fait l'objet d'une publication de demande de brevet antérieure (WO2007148028).

L'utilisation de magnétorésistances tunnel permet en outre d'obtenir une configuration présentant une très faible consommation électrique.

L'invention concerne également un système de diagnostic de mesure de tension ou de courant d'un générateur électrique, caractérisé en ce qu'il comprend au moins un module hybride de mesure comprenant une pluralité de capteurs de mesure de tension via un courant ou de mesure de courant à magnétorésistance géante tels que définis plus haut intégrés sur une même barrette, un module d'amplification comprenant une pluralité d'amplificateurs recevant les signaux délivrés par ladite pluralité de capteurs, un module de multiplexage, un dispositif de liaison et un module séparé de traitement numérique.

Selon une caractéristique avantageuse de l'invention, le module hybride de mesure comprend un premier circuit imprimé contenant ladite barrette de capteurs et le module d'amplification et un deuxième circuit imprimé contenant le module de multiplexage, des pistes d'échanges de signaux étant formées sur les tranches des circuits imprimés, et les premier et deuxième circuits imprimés étant assemblés, moulés et encapsulés avec des bornes de connexion d'entrée-sortie reliées auxdites pistes d'échange de signaux formées sur les tranches des circuits imprimés et connectées audit dispositif de liaison.

Le module de traitement peut comprendre au moins une unité de traitement, des entrées analogiques et des convertisseurs analogique-numérique, des entrées-sorties TOR de type tout ou rien et un circuit imprimé assurant l'ensemble des liaisons entre le module hybride de mesure et le module de traitement.

Selon un mode de réalisation préférentiel, chaque capteur intégré de mesure de tension ou de courant à magnétorésistance géante comprend des première et deuxième bornes de connexion à une cellule individuelle du générateur dont la tension ou le courant est à mesurer et une ligne de mesure métallique comprenant des premier et deuxième tronçons allongés et parallèles dans lesquels le courant circule en sens opposés, reliés à une portion destinée à fermer la ligne de mesure, l'ensemble de la ligne de mesure étant disposée sur une couche d'isolation galvanique, elle-même disposée sur une portion de circuit intégré comprenant un pont de magnétorésistances géantes et des pistes de liaison à au moins un contact de polarisation en tension Vcc, un contact de masse et des contacts de pôles négatif V- et positif V+ d'une tension différentielle de sortie, les magnétorésistances géantes présentant elles-mêmes la forme d'un C avec une branche centrale longitudinale constituant une partie sensible de la magnétorésistance qui est essentiellement superposée à l'un des tronçons allongés de la ligne de mesure.

Le système peut comprendre en outre une résistance disposée entre un point de mesure de chaque cellule du générateur électrique et la borne d'entrée correspondante de la barrette de capteurs, afin d'étendre la plage de mesure de tension sans reconfigurer tout le système.

Selon un mode particulier de réalisation, donné à titre d'exemple, chaque barrette comprend huit capteurs de mesure de tension ou de courant à magnétorésistance géante, le module d'amplification comprend également huit amplificateurs et le module de multiplexage comprend au moins trois étages avec sept cellules élémentaires de multiplexage activées par trois signaux de sélection.

Un circuit de compensation du décalage initial peut être associé à chaque amplificateur.

Selon une autre caractéristique particulière, un circuit de compensation de point de polarisation déterminant une masse flottante peut être associé à chaque amplificateur.

Le système selon l'invention est avantageusement appliqué à la mesure de la tension ou du courant d'un générateur comprenant une pluralité de cellules de pile à combustible présentant une tension de sortie comprise entre 0 et 1,3 V et, plus généralement, de tout générateur comprenant une pluralité de cellules présentant une tension pouvant être ramenée dans la gamme comprise entre -1,2V et +1,2V.

L'invention proposée permet de résoudre plusieurs problèmes importants non résolus dans les travaux de l'art antérieur.

Ainsi, la conception modulaire du système permet une mise en oeuvre aisée, facilite une adaptation à des générateurs à grands nombres de cellules élémentaires et minimise les sources de bruit externes venant principalement de la connectique.

L'invention permet également d'avoir une isolation galvanique importante entre la ligne de courant et le pont de résistances GMR tout en définissant un capteur totalement intégré. Alors que des distances de l'ordre du mm sont en général utilisées, la technologie proposée permet d'avoir les lignes de courant situées typiquement à 8$\mu$m du pont de GMR.

La taille et la conformation du pont de GMR choisi permettent d'obtenir des linéarités compatibles avec les spécifications nécessaires pour l'application visée.

Selon cette caractéristique intrinsèque de l'invention, l'utilisation dérivée d'une source d'alimentation externe, comme la batterie véhicule sur les applications automobiles, dès le pont de résistances GMR, simplifie la conception des unités d'instrumentation nécessaires à ce pont, et plus globalement des modules de traitement associés.

La configuration particulière des capteurs et des lignes de courant permet de mettre en oeuvre une fonction fusible intégrée qui fait qu'en cas de surtension trop importante ou de décharge électrostatique dépassant les 2kV, la ligne de courant intégrée peut servir de fusible instantané.

Brève description des dessins

D'autres caractéristiques et avantages de l'invention ressortiront de la description suivante de modes particuliers de réalisation, donnés à titre d'exemples, en référence aux dessins annexés, sur lesquels :

- la Figure 1 est une vue schématique en coupe montrant à titre d'exemple les éléments constitutifs d'un capteur magnéto résistif de type vanne de spin GMR ou TMR,

- la Figure 2 montre une courbe de réponse typique d'un capteur de type GMR, tel que par exemple celui de la Figure 1, respectivement sans et avec optimisation de la configuration,

- les Figures 3A et 3B sont des vues schématiques des configurations d'une magnétorésistance tunnel montrant la prise des contacts selon deux variantes de réalisation,

- la Figure 4 est une vue schématique d'un mode de réalisation particulier possible d'une configuration de capteur intégré à GMR, pont de mesure et ligne de mesure métallique selon l'invention,

- la Figure 5 est une vue schématique du circuit électrique du capteur intégré du mode de réalisation de la figure 4,

- la Figure 6 est un schéma partiel d'un capteur intégré selon l'invention avec une variante de réalisation de la ligne de courant de mesure conférant une fonction de fusible intégré,

- la Figure 7 est une vue schématique de dessus montrant une barrette de mesure dans laquelle sont intégrés une pluralité de capteurs de mesure mettant en oeuvre des capteurs magnétorésistifs de type GMR,
- la Figure 8 est un schéma synoptique de principe de l'ensemble d'un système de diagnostic selon l'invention,
- la Figure 9 est un schéma d'exemple de cellule élémentaire d'amplification utilisable dans le cadre de l'invention,
- la Figure 10 est un schéma d'exemple de cellule élémentaire de multiplexage utilisable dans le cadre de l'invention,
- la Figure 11 est un exemple de module de multiplexage utilisable dans un mode particulier de réalisation de l'invention,
- la Figure 12 est un schéma d'un circuit montrant la compensation du décalage initial d'une cellule élémentaire d'amplification,
- la Figure 13 est un schéma d'un circuit montrant la compensation au point milieu, et
- la Figure 14 est une variante du schéma synoptique de la Figure 8 qui permet une adaptation à des tensions de cellule plus importantes.

Description détaillée de modes particuliers de réalisation

L'effet GMR de magnétorésistance géante (« Giant Magnetoresistive effect ») et l'effet TMR (« Tunnel Magnetoresistive Effect ») sont observés dans des films minces métalliques composés de couches de matériaux ferromagnétiques et non ferromagnétiques. Il se manifeste par une variation importante de la résistance électrique de ces structures en présence d'un champ magnétique. La configuration usuelle d'une magnétorésistance est une vanne de spin composée d'une couche dure (qui est insensible au champ magnétique) et d'une couche libre qui est en libre rotation dans le champ magnétique. La résistance de ce système change en fonction de l'angle entre la couche dure et la couche libre. Dans le cas des GMR, les deux couches sont séparées par une couche métallique et les contacts de mesure se prennent sur le dessus de l'ensemble des couches. Dans le cas des TMR, les deux couches sont séparées par une couche isolante et les contacts de mesure se prennent en dessous et au dessus de l'ensemble des couches.

Pour les capteurs utilisés dans le cadre de la présente invention, la configuration préférentielle est d'avoir l'orientation en absence de champ magnétique de la couche libre perpendiculaire à la direction de la couche bloquée. Cela est réalisé d'une part en utilisant la forme du capteur, d'autre part en appliquant un champ de polarisation (« bias ») contrôlé. La direction de la couche bloquée est obtenue par recuit sous champ magnétique fort, typiquement à 260°c et 0,1T pendant quelques minutes.

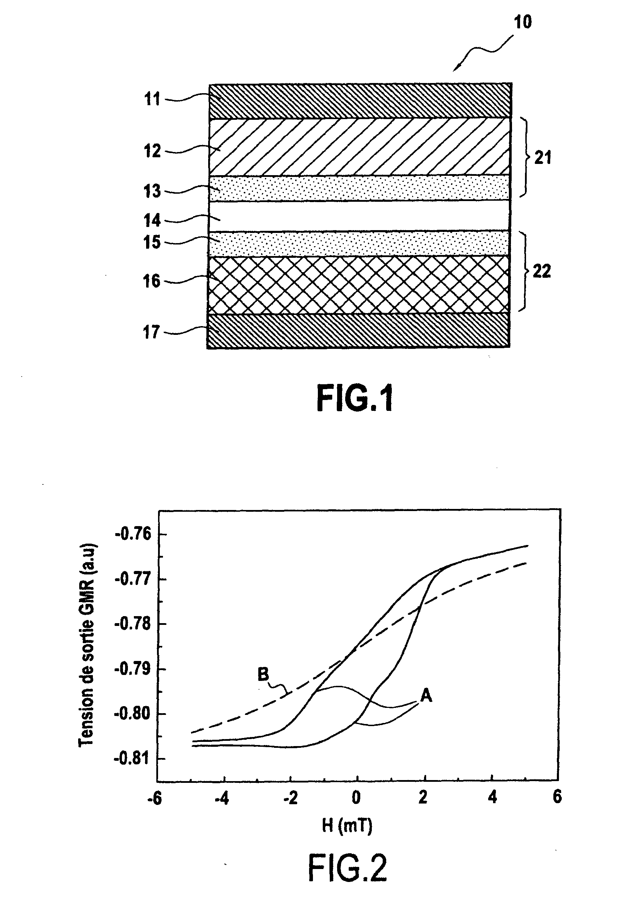

La figure 1 montre un exemple de représentation de cet assemblage de films minces qui constitue un capteur magnétorésistif 10 de type GMR ayant la structure d'une vanne de spin, et qui est décrit par exemple dans le document Fr 2876800.

Une vanne de spin contient typiquement une couche dure ou bloquée 22, c'est-à-dire une couche peu sensible au champ magnétique extérieur, et une couche douce ou libre 21, très sensible au champ magnétique.

La couche dure 22 peut être formée soit d'un assemblage de couches ferromagnétiques présentant une forte coercivité, soit d'un mélange de couches antiferromagnétiques, artificielles ou non, couplées à une couche ferromagnétique.

La couche douce est formée de matériaux magnétiques très doux.

A titre d'exemple, le capteur magnétorésistif 10 de la Figure 1 peut comprendre à partir de la surface libre une couche 11 de protection en tantale, une couche magnétique douce 21 comportant une couche 12 de NiFe et une couche 13 de CoFe. Cette couche douce 21 s'oriente dans la direction du champ magnétique extérieur.

Une couche magnétique dure 22 est séparée de la couche douce 21 par une couche séparatrice 14 en cuivre. La couche magnétique dure 22 peut comprendre à partir de la couche séparatrice 14, une couche 15 en CoFe et une couche 16 en IrMn. La couche dure 22 possède une direction de l'aimantation fixée lors de la fabrication. Une couche 17 de tantale peut servir de précurseur de croissance de couches supérieures ajoutées pour la mise en oeuvre du circuit.

A titre d'exemple, l'assemblage de feuilles de la figure 1 peut présenter une épaisseur d'environ 30nm, tandis que les dimensions de l'ensemble de la cellule peuvent être typiquement de $200\mu m * 30\mu m * 5\mu m$.

Comme expliqué dans la publication « Low noise magnetoresistive sensors for current measurement and compasses » Pannetier-Lecoeur, M; Fermon, C; de Vismes, A, et al. JOURNAL OF MAGNETISM AND MAGNETIC MATERIALS Volume: 316 Issue: 2 Pages: E246-E248 Published: 2007, l'utilisation de capteurs en forme de C permet de réduire fortement le bruit magnétique. De plus, l'application d'un champ magnétique longitudinal permet de contrôler parfaitement la réponse de chaque capteur GMR. Ce sont donc ces configurations optimisées qui sont retenues.

La figure 2 montre une réponse typique (tension de sortie) d'une vanne de spin en fonction du champ appliqué H dans un cas ou la forme et le champ de polarisation ne sont pas optimisés (courbe A) et dans le cas où ils le sont (courbe B).

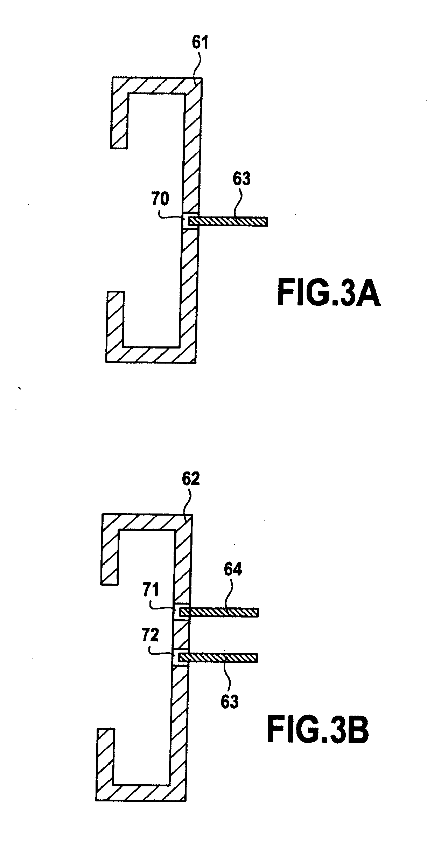

Les figures 3A et 3B montrent des configurations de mesure d'une magnétorésistance tunnel. La figure 3A correspond à une configuration avec un seul plot 70 de magnétorésistance tandis que la figure 3B montre un mode de réalisation qui correspond à une configuration avec deux plots 71, 72 de magnétorésistance. La configuration à deux plots est avantageuse car elle permet de doubler la tension acceptable aux bornes de la magnétorésistance et donc d'avoir deux fois plus de sensibilité.

Sur la figure 3A, on voit une culasse 61 en forme de C dans la couche libre d'une TMR correspondant au contact inférieur et un deuxième contact de mesure 63 de la TMR situé au-dessus, au niveau du plot 70.

Sur la figure 3B, on voit une culasse 62 en forme de C dans la couche libre d'une TMR sans contacts, un premier contact de mesure 64 de la TMR situé au-dessus au niveau du plot 71 et un deuxième contact de mesure 63 de la TMR situé au-dessus, au niveau du plot 72.

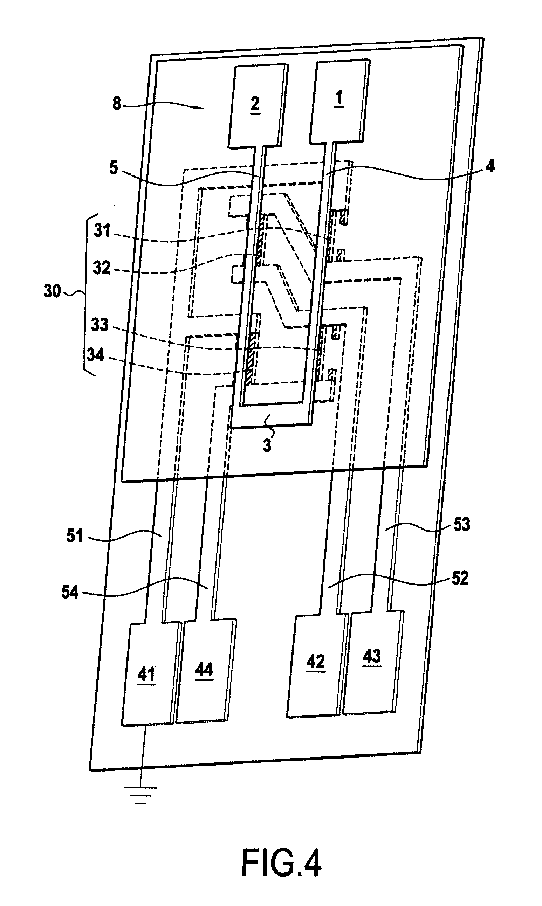

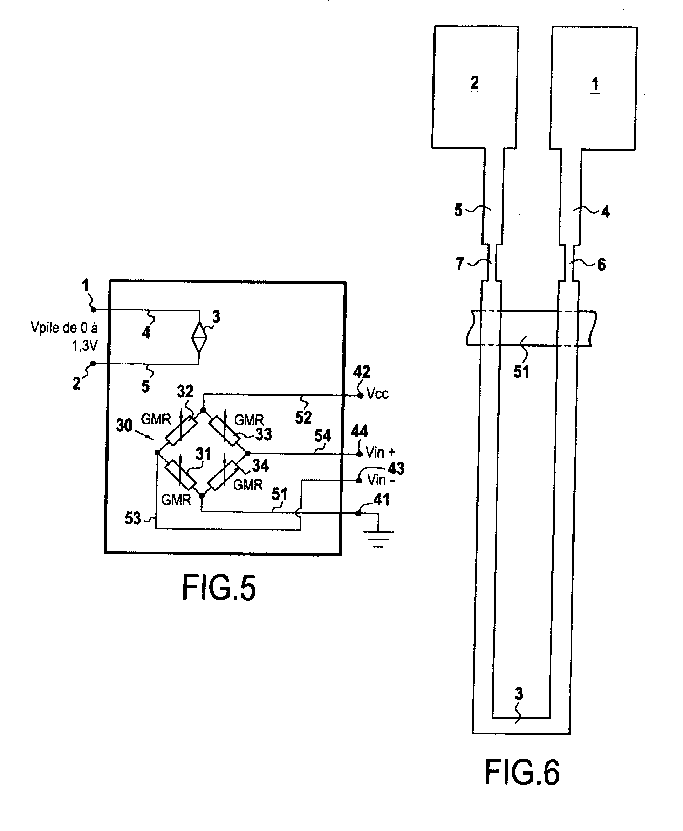

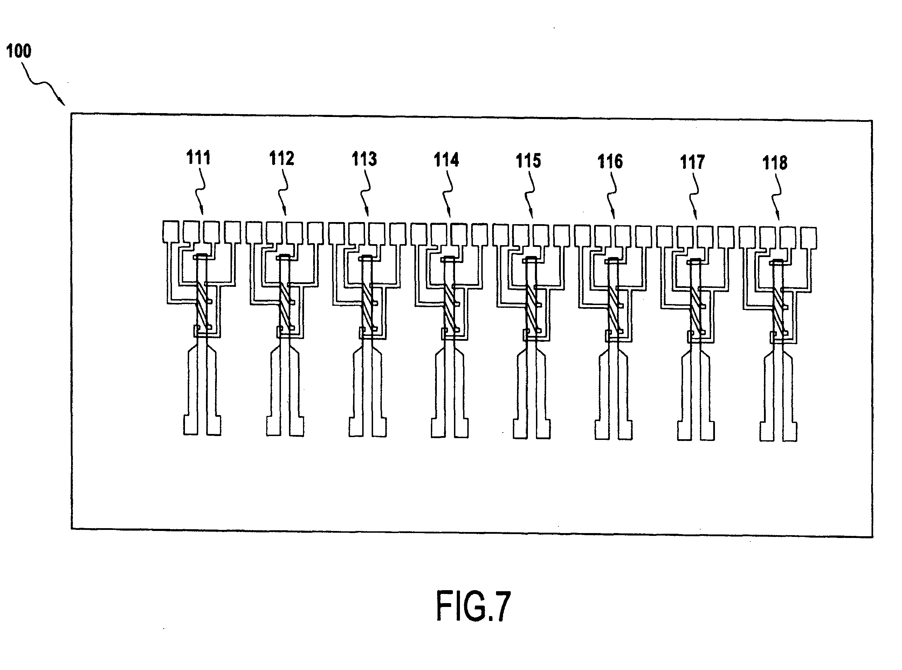

Les figures 4 et 5 illustrent le principe retenu pour l'intégration des GMR dans le capteur selon l'invention, qui peut être un capteur individuel 111 à 118 lui-même intégré dans une barrette 100, comme représenté sur la figure 7.

Dans le cadre de la présente application, la polarisation est imposée par l'alimentation à tension constante entre une tension continue Vcc et la masse. Une cellule GMR 30 comprend quatre GMR 31, 32, 33, 34 montées en pont. Le courant de chacune des branches du pont est proportionnel à la résistance des GMR, donc à leur variation en présence d'un champ, ce qui est le principe même de la mesure de tension de cellule.

La figure 4 représente un exemple de cellule GMR avec un pont complet 30 de quatre GMR, une couche d'isolation galvanique 8 et une ligne de mesure métallique, avec des première et deuxième bornes 1, 2 de connexion à un générateur dont la tension ou le courant est à mesurer et une ligne de mesure métallique comprenant des premier et deuxième tronçons allongés 4, 5 reliés à une portion 3 disposée transversalement par rapport aux premier et deuxième tronçons 4, 5 et destinée à fermer la ligne de mesure. L'ensemble de la ligne de mesure 3, 4, 5 est disposée sur la couche d'isolation galvanique 8, elle-même disposée sur une portion de circuit intégré comprenant le pont 30 de magnétorésistances géantes et des pistes 52, 51, 53, 54 de liaison à au moins un contact de polarisation en tension Vcc 42, un contact de masse 41 et des contacts 43, 44 de pôles négatif Vin- et positif Vin+ d'une tension différentielle de sortie.

Les magnétorésistances géantes 31, 32, 33, 34 présentent elles-mêmes la forme d'un C avec une branche centrale longitudinale qui est essentiellement superposée à l'un des tronçons allongés 4, 5 de la ligne de mesure métallique. Il est important de noter que toutes les GMR répondent de façon identique au champ magnétique extérieur ce qui implique qu'une perturbation magnétique extérieure ne déséquilibre pas le pont. Par contre, comme la ligne de mesure métallique comprend deux segments alignés avec les GMR qui sont parcourus par des courants de sens opposés, son action est opposée et donc l'apparition d'un courant dans la ligne de mesure métallique crée un déséquilibre du pont.

La figure 4 montre un assemblage électrique en pont tel que mis en oeuvre dans l'invention pour garantir la précision optimum tout en s'affranchissant des champs récurrents parasites (terrestre, environnement, ...). La figure 5 montre le mode de fonctionnement en pont.

On donnera maintenant quelques considérations sur le calcul de la réponse du système.

La Tension cellule de pile $V_{PILE}$ crée un courant $I_{BIAS}$ selon la formule

$$I_{bias} = V_{pile} / R_{ligne\_de\_courant}$$

A partir de Ibias, on peut déterminer le champ magnétique vu par les capteurs GMR. Il peut s'écrire : $B = \alpha . I_{bias}$ où le paramètre $a$ dépend de la taille des résistances GMR, de la taille de la ligne de courant et de la distance entre les résistances GMR et la ligne de courant.

La sensibilité se détermine à partir de la résistance GMR $R_{GMR}$. En première approximation, la variation de résistance $\Delta R_{GMR}$ en présence de champ magnétique est une fonction linéaire de ce champ. La variation est typiquement $\dfrac{\Delta R_{GMR}}{R_{GMR}} = 0.02.B$ ou B est exprimé en mT.

Lors d'un montage en pont comme représenté sur la figure 5, la tension différentielle de sortie est calculée à partir des valeurs données ci-dessus. Les résistances GMR sont conçues afin d'être le plus homogènes possibles. Elles sont disposées au-dessus de la ligne de courant de manière à pouvoir être sensibilisées par un champ magnétique opposé. Cela permet d'accroître la sensibilité du pont et d'éliminer les champs parasites environnants (champ terrestre, ....). En admettant que la variation des résistances $R_{GMR}$ soit homogène et égale à $\Delta R_{GMR}$, l'équation de transfert peut s'écrire : $Vin_+ - Vin_- = Vcc * \Delta R_{gmr} / R_{gmr}$

Les différents coefficients de transfert étant linéaires ou quasi-linéaires en première approximation, on en déduit que $Vin_+-Vin_-$ est proportionnelle à la tension de cellule de pile $V_{PILE}$.

La tension différentielle délivrée par ce transducteur reste faible et est caractérisée par deux paramètres principaux, le décalage entre les branches du pont lorsqu'aucune tension n'est délivrée par la cellule de pile (appelé OFFSET) et la dynamique issue de la sensibilité du transducteur en présence de champ magnétique découlant de la présence de tension aux bornes de la cellule de pile.

Le décalage est essentiellement introduit par une non-homogénéité des quatre résistances formant le pont, la dynamique étant elle-même plus liée à la technologie des matériaux du transducteur.

La sensibilité typique d'une cellule GMR est de 50mV aux bornes du pont pour une tension de 1,3V. En ayant une linéarité meilleure que 1%. L'offset dépend de la qualité de fabrication, mais doit préférentiellement être inférieur à 20mV.

Le bruit du système après optimisation des tailles et formes du capteur est principalement relié au bruit basse fréquence des éléments GMR. Le bruit intégré sur une bande allant du courant continu à une fréquence de 100Hz est typiquement de 50nV RMS ce qui donne un bruit en tension au niveau de la mesure de 1,4$\mu$V RMS.

On indiquera maintenant le principe de l'optimisation des tailles et des formes du capteur.

La ligne de mesure métallique 3, 4, 5 connectée à la cellule de pile à combustible mesurée en tension, ou à tout autre générateur du même type, est séparée du pont de mesure GMR 30 par une couche d'isolation 8 optimisée pour garantir l'isolation galvanique requise pour l'application automobile, c'est à dire 1500V.

L'alimentation du pont 30 peut donc être obtenue par une source externe stabilisée. Une utilisation de 3,3V ou 5V est souvent utilisée pour avoir une compatibilité directe avec les circuits électroniques standard.

On peut remarquer que ce capteur assure deux fonctionnalités fondamentales pour l'application de la présente invention:

- assurer le rôle de transducteur en disposant d'une sortie traditionnelle d'un pont de mesure (Vin+ - Vin-), donnant directement une valeur proportionnelle à la tension de la cellule de pile à combustible mesurée,

- assurer l'isolation galvanique au plus près de la mesure, évitant d'intégrer dans la chaîne d'acquisition des étages spécifiques de conditionnement des signaux pour garantir l'isolation galvanique de 1500V (contrairement à des dispositifs de l'art antérieur devant mettre en oeuvre une conversion temps-fréquence et des opto-coupleurs par exemple).

Par ailleurs, la conception de la ligne de mesure métallique se prête à une variante de réalisation très avantageuse, illustrée sur la figure 6 et décrite ci-dessous, où cette ligne de courant assure une fonction fusible auto protégeant la cellule de pile à combustible en cas de courant excessif au niveau de la cellule de mesure.

La fonction d'auto fusible est assurée grâce à l'intégration dans la ligne de mesure d'au moins un rétrécissement ou micro-constriction 6, 7 qui sert de fusible dans le cas d'un défaut d'isolation créé par un pic de surtension.

La ligne 51 d'alimentation de la masse passe sous la ligne métallique, comme représenté sur les figures 4 et 6. Au voisinage de ce point de passage, les tronçons allongés 4, 5 de la ligne métallique contiennent un rétrécissement 6, 7 légèrement décalé en direction des bornes de connexion 1, 2. En cas de pic de surtension initiant un claquage et donc un risque de lien entre l'alimentation de la pile et le circuit basse tension du pont 30, le rétrécissement décalé 6, 7 se vaporise et isole le composant de mesure qui a alors servi d'auto-fusible.

Un certain nombre de paramètres permettent de définir la structure optimale pour avoir la linéarité et la dynamique recherchée pour un capteur intégré selon l'invention.

L'optimisation de la taille et de la forme des GMR se base sur plusieurs critères :

- La résistance recherchée, de l'ordre de 500 Ohms par bras du pont. Cela fixe des longueurs de GMR de l'ordre de 200$\mu$m pour 5$\mu$m de largeur, sachant que la résistance par surface carrée d'un empilement GMR est d'environ 12 Ohms. Dans le cas de TMR, la surface du plot fixe la résistance. Une résistance de 500 Ohms est aussi visée.

- La largeur de la GMR ou TMR est préférentiellement choisie entre 4$\mu$m et 8$\mu$m. Cela assure une linéarité de réponse suffisante avant application d'un champ de polarisation mais il est possible de choisir des largeurs plus faibles si les tensions à mesurer sont plus élevées.

- La forme des magnétorésistances est en C (voir les figures 3A et 3B), de telle sorte que le bruit magnétique soit réduit dans la zone de mesure.

Un point important est l'homogénéité de fabrication des GMR qui doit assurer un offset du pont inférieur à 1%.

Il est à noter que la réponse intrinsèque des magnétorésistances GMR et TMR présente une variation en sensibilité d'environ 8% sur la plage de température. Cette variation de sensibilité peut être compensée en dimensionnant le champ de stabilisation longitudinal si par exemple celui-ci est créé par un aimant permanent ayant dans la plage de température voulue une décroissance en champ du même ordre.

Le choix de la taille et de l'épaisseur de la ligne de courant se fait avec les critères suivants :

- La résistance de la ligne de mesure métallique doit être ajustée pour que la tension de 1,5V délivre 20mA par exemple. Cela correspond à une résistance de 75 Ohms. Des valeurs de courant entre 5 et 30mA sont préférentiellement choisies selon le critère de minimiser le courant tiré de la batterie et de minimiser la puissance dissipée dans le composant tout en gardant une sensibilité suffisante par rapport à la résolution voulue.

- La résistance de la ligne est donnée par la largeur de celle-ci et par son épaisseur. On choisira avantageusement une largeur de ligne comparable et plus grande que la largeur des magnétorésistances. Une largeur trop petite, (inférieure à 3$\mu$m) induira une reproductibilité moindre de la résistance. Une largeur trop grande nuira à la réponse du capteur. Des largeurs comprises entre 4$\mu$m et 20$\mu$m sont pré-

férentiellement choisies.

La résolution voulue est déterminée par le bruit du pont 30 de magnétorésistances. A basse fréquence, celui-ci est dominé par les fluctuations de résistance présentant une densité spectrale en 1/f. Pour un pont dessiné suivant les critères de taille et de forme définis plus haut, le bruit est d'environ 25nT RMS. Avec une largeur de ligne de courant égale à la largeur de la constriction et une épaisseur d'isolation de 5$\mu$m, cela correspond à une détectabilité en courant de 10$\mu$A.

La qualité et la planéité de la couche d'isolation galvanique 8 est un point crucial dans les performances du dispositif. La couche doit être suffisamment épaisse pour assurer l'isolation galvanique requise (1500V à 3000V) et suffisamment plane pour que la croissance de la ligne de mesure 3, 4, 5 et sa liaison au monde extérieur (bornes de connexion 1, 2) soit faisable.

Compte tenu du caractère intégré de cet isolant, la ligne de courant est directement déposée sur l'une de ses faces et la magnétorésistance en C sur l'autre face, sa partie sensible directement placée en vis-à-vis. Ainsi, l'isolation galvanique s'obtient directement en multipliant l'épaisseur du support par la capacité d'isolation du matériau de ce support.

Par exemple, dans un mode de réalisation préférentiel, qui donne des couches très planes et de bonne tenue diélectrique, on utilise une couche de Al$_2$O$_3$ déposée par pulvérisation cathodique sous vapeur d'Argon+Oxygène. L'isolation galvanique est de 400V par $\mu$m déposé.

La double caractéristique « isolation galvanique intégrée » et « épaisseur inférieure ou égale à 8 $\mu$m » revient d'ailleurs à dire, compte tenu de l'intégration, que la distance ligne de courant / magnétorésistance est aussi au plus de 8 $\mu$m. De même, un support de 6$\mu$m assure une isolation théorique de 3200V et une isolation pratique dépassant les 2000V. Cette technique permet d'obtenir des couches de très bonne qualité mais avec des temps de dépôt relativement longs. Une alternative consiste à déposer Al$_2$O$_3$ par une autre technique, le système de dépôt en phase vapeur activé par plasma ou PECVD (« Plasma Enhanced Chemical Vapor Deposition »), qui donne aussi de bons résultats avec des temps de dépôt plus courts.

On peut aussi envisager des supports isolants basés sur des dépôts de résines durcies (poly-imides, BCB (Bisbenzocyclotène) par exemple) ou des dépôts d'isolants céramiques (Si$_3$N$_4$, AL$_2$O$_3$ par exemple). Connaissant les propriétés diélectriques de ces matériaux, et l'épaisseur du support, sa tenue diélectrique en découle immédiatement.

Le développement de capteurs de courant à base de magnétorésistances permet d'envisager des solutions très intégrées et avec une résolution inégalée. En particulier, l'isolation galvanique intégrée permet d'atteindre des résolutions de 10$\mu$A alors que les capteurs existants adaptés au domaine automobile se situent dans le domaine du mA ou même de 10mA et en outre ne permettent pas de mettre en oeuvre la fonction d'auto-fusible.

Selon l'invention, la combinaison de la forme en C des capteurs, et de cette faible distance ligne de courant / magnétorésistance définit deux caractéristiques qui améliorent très significativement le rapport signal sur bruit ; et leur combinaison est particulièrement avantageuse. En outre, on a déjà indiqué plus haut que cette isolation intégrée permet l'auto-fusible.

Plus généralement, on peut noter que cette intégration permet d'obtenir à la fois une forte isolation et une très faible distance entre la ligne de courant et la magnétorésistance. Concilier ces deux caractéristiques a priori contradictoires permet un rapport S/N (signal sur bruit) beaucoup plus élevé que dans les réalisations de l'art antérieur.

La technologie GMR et TMR, telle qu'appliquée au domaine automobile présente notamment les intérêts suivants :

- Technologie développée pour la mesure de tensions (positives et négatives) avec une grande précision (typiquement de 10 mV) et justesse assurée par le principe d'étalonnage,,
- Technologie permettant intrinsèquement la mesure de courant,
- Sûreté de fonctionnement du dispositif de diagnostic pile assuré intrinsèquement par les magnétorésistances,
- Isolation galvanique assurée par le capteur lui-même,
- Le capteur assure une fonction sécuritaire de fusible en cas de surintensité,
- Précision des mesures : technologie très bien adaptée à la mesure des faibles courants comparativement aux capteurs à effet Hall qui sont les seuls composants concurrents dédiés à la mesure de courant,
- Compacité de la technologie, simple à intégrer notamment pour des applications embarquées,
- Possibilité de connecter directement les composants intégrés sur la pile à combustible,
- Robustesse des mesures, même dans un environnement sévère avec perturbations électromagnétiques,
- Technologie pouvant être intégrée sur une puce de coût de fabrication faible par rapport aux technologies partiellement concurrentes, induit par un champ d'application très large qui permet d'envisager une production à fort volume,
- Faible consommation énergétique (< à 1 mA par pont), hors consommation de la ligne de courant dans la résistance de polarisation 3 dont la consommation est ajustable en fonction du besoin,
- Capteur autonome de mesure de tension ne nécessitant pas de composants annexes pour réaliser la fonction (ligne de courant externe, câble, ...)
- Le domaine d'application est particulièrement étendu et intéressant pour le monde automobile avec l'avènement des véhicules électriques et hybrides (thermique/ électrique, ...), le capteur selon l'invention étant adapté à toutes mesures de courant ou de tension d'un générateur électrique,

- Application à la gestion de la charge de batteries ou de super capacités,
- Surveillance de la tension individuelle de cellules de pile à combustible,
- Applicable aux électrolyseurs,
- Instrumentation / diagnostic sur toute technologie électrotechnique nécessitant une/des mesures de courant / tension.

La cellule élémentaire de capteur telle que décrite ci-dessus et représentée sur la figure 4 peut être dupliquée sur un même support pour intégrer un certain nombre de voies de mesure.

Ainsi, sur la figure 7, on a représenté une barrette 100 sur laquelle sont intégrées huit cellules élémentaires de capteur de mesure 111 à 118 à magnétorésistance géante (GMR). Le nombre de huit cellules est pratique et compatible avec des méthodes de fabrication analogues à celles relatives aux composants microélectroniques, mais l'invention n'est naturellement pas limitée à un tel nombre de cellules élémentaires.

A titre d'exemple, la barrette de la figure 7 comportant huit cellules élémentaires de mesure peut présenter une surface de 4 x 13 mm.

Les méthodes employées pour la réalisation de la barrette 100 ont toutefois mis en évidence l'existence d'un signal de décalage entre les branches d'une même cellule GMR en l'absence de tensions de cellule de pile et d'une dispersion entre cellules affectant ce décalage, mais également la dynamique de la tension différentielle mesurée en présence de tension sur la cellule de pile.

Ces paramètres dépendent des technologies employées et de la méthode de fabrication des cellules GMR.

On a retenu pour l'application cible les chiffres de +/-60 mV pour le décalage de branches et +/-80mV pour la dynamique de la cellule GMR. La tension V+-V- peut ainsi varier en moyenne de -140 mV à +140 mV.

La stabilisation et l'homogénéité de ces paramètres peuvent être améliorées si le transducteur est fabriqué selon des méthodes industrielles comparables à celles mises en oeuvre pour les composants électroniques.

La barrette 100 permet de disposer de signaux analogiques issus des cellules GMR de très faible amplitude. Il est donc nécessaire d'ajouter des étages spécifiques tels qu'au minimum l'amplification 200 et le multiplexage 300 avant de convertir le signal analogique en donnée numérique compatible avec un calculateur embarqué 400.

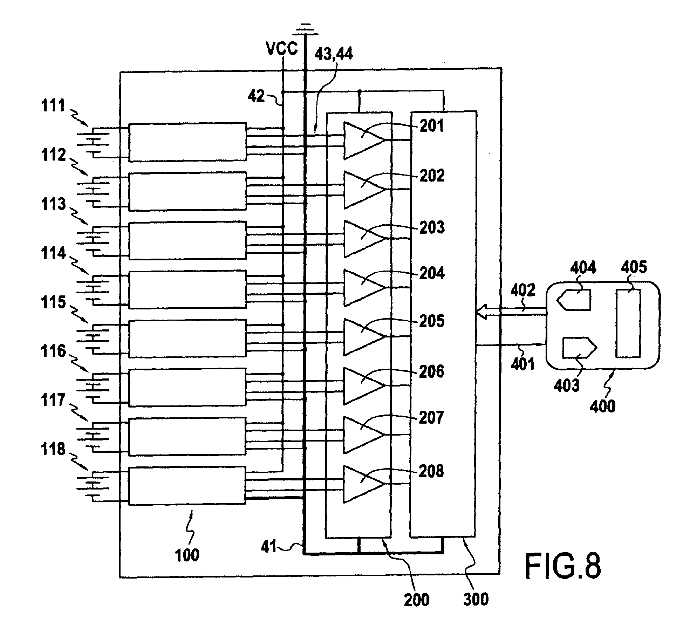

Le schéma synoptique de la figure 8 reprend ces différents blocs fonctionnels 100, 200, 300 et 400.

On distingue sur la figure 8 la barrette GMR 100 constituée de 8 structures regroupant la cellule GMR 111 à 118 et son module associé d'amplification 201 à 208.

On peut dire en première approximation que la dynamique de 80 mV correspond à une variation de la tension de cellule de pile comprise entre 0V et 1,3V. On en déduit le gain de l'ordre de 10-15 que doit présenter l'étage d'amplification 200 pour délivrer une tension comparable dans un rapport proche de 1 avec la tension de cellule de pile.

Un module 300 de sélection de voies permet de multiplexer, pour la lecture vers un module externe 400, les 8 voies de la barrette 100 sur une voie de sortie 401.

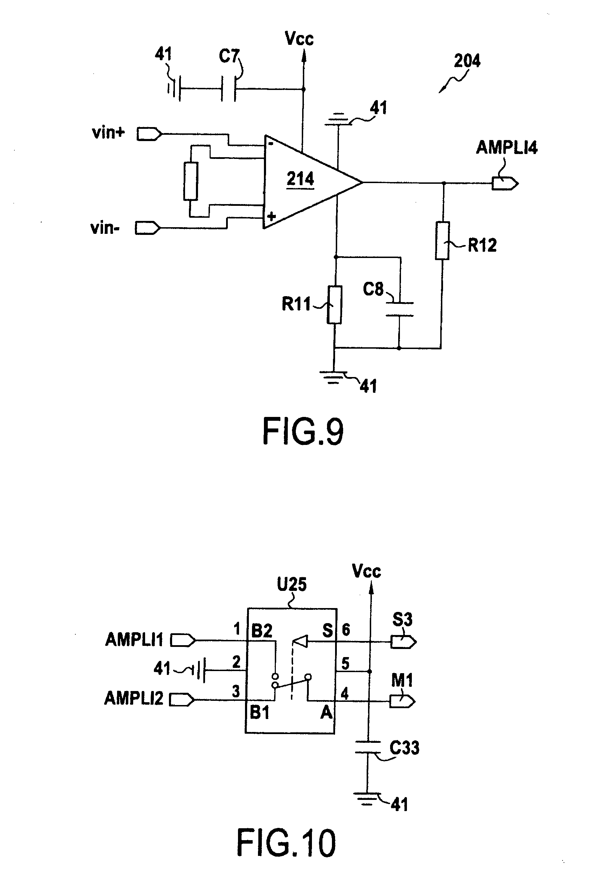

Le schéma électronique de la figure 9 montre un exemple de cellule d'amplification (la cellule 204, mais les autres cellules 201 à 203 et 205 à 208 sont analogues) constituée d'un amplificateur d'instrumentation U4 adapté pour les signaux délivrés par la cellule GMR correspondante (ici la cellule 114 reliée par des bornes 4Vin+ et 4Vin- à l'amplificateur U4). Ce composant fonctionne selon les gammes de tension usuelles des composants CMOS actuels, soit pour le composant retenu, une alimentation mono-tension 0-3,3V. Le gain G est défini par la formule $G=2*R11/R10$.

Les entrées VIN+ et VIN- correspondent aux sorties différentielles 44 et 43 du pont de GMR 30.

Le signal AMPLIx est le signal amplifié par la cellule d'amplification. Il est défini par $AMPLIx= G *(VIN+ - VIN-)$.

La cellule élémentaire de multiplexage U25 représentée sur la figure 10, qui est choisie dans une technologie compatible avec les signaux délivrés par les amplificateurs qui la précèdent (ici les amplificateurs 111 et 112 pour la première cellule élémentaire de multiplexage U25 de la figure 10), multiplexe deux voies vers une voie. Cela sous-entend que pour lire les huit voies de la barrette GMR 100 des figures 7 et 8, le module de sélection comprend trois étages ($2**3$ donnant 8) permettant de choisir 4 voies, puis 2 voies puis une voie.

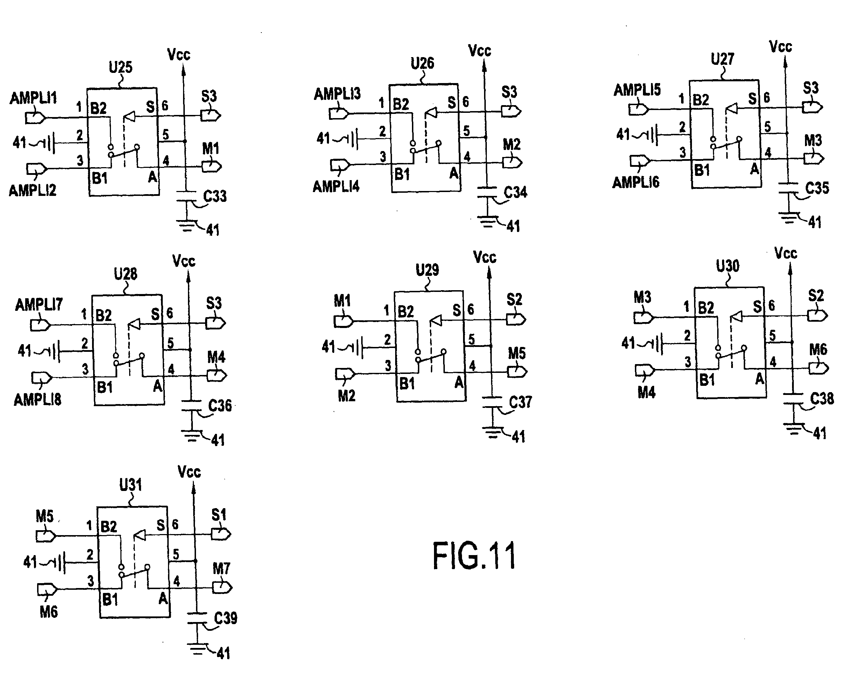

Comme le montrent les figures 10 et 11, le signal S3 permet de sélectionner les sorties AMPLI1 et AMPLI2 vers le signal sélectionné M1, pour la première cellule élémentaire de multiplexage U25.

Le module de sélection 300 comprend donc ici sept cellules élémentaires de multiplexage U25 à U31 activées par trois signaux de sélection Si agissant sur chacun des étages (Figure 11).

Le signal S3 permet de sélectionner parmi les huit sorties AMPLIi, quatre signaux intermédiaires Mj ($1<=j <=4$) constituant les entrées du second étage. Le signal S2 permet de sélectionner parmi les signaux Mj deux signaux intermédiaires Mk ($5<=k<=6$) constituant les entrées du troisième étage. Le signal S1 permet de sélectionner parmi les signaux Mk la sortie AMPLIi, (signal final M7) envoyée au module externe 400. Les cellules élémentaires de multiplexage U25 à U28 constituent ainsi le premier étage, les cellules élémentaires de multiplexage U29 et U30 constituent le deuxième étage et la cellule élémentaire de multiplexage U31 constitue le troisième étage.

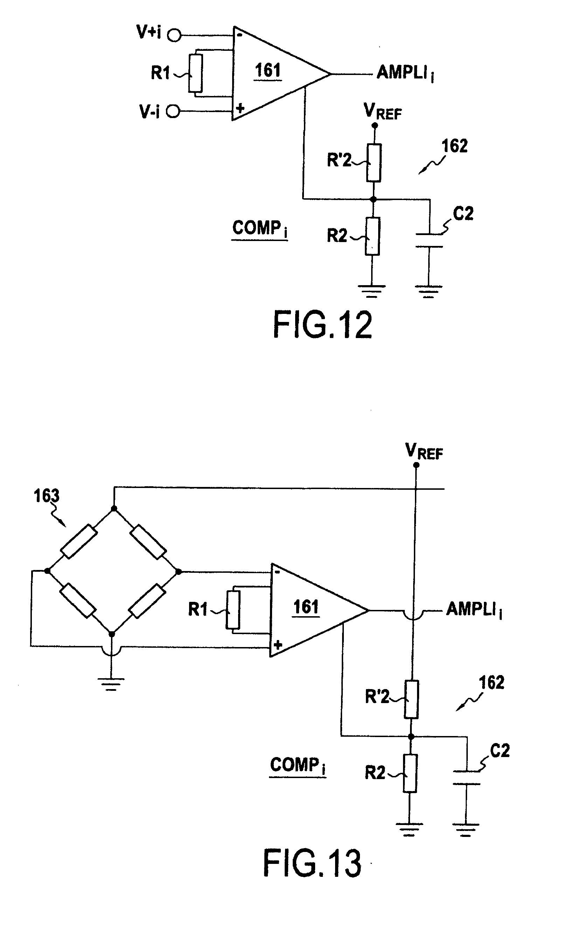

Une variante de cette implémentation permet de prendre en compte les dérives intrinsèques induites par le décalage à l'origine. Ainsi, selon un mode particulier de réalisation illustré sur la figure 12, un signal de compensation COMPi est ajouté au signal amplifié AMPLIi afin de réduire ou supprimer l'influence du décalage (offset).

Ce signal est déterminé dans un circuit 162 à partir d'un signal VREF selon la formule VREF*R2/(R2+R'2), qui peut être soit la tension d'alimentation des différents modules VALIM, soit un signal externe.

Le gain de la cellule ainsi défini est modifié et défini selon la formule G=2*(R2//R'2)/R1.

Ce principe nécessite de connaître avec assez de précision le décalage à l'origine des transducteurs qui sont utilisés pour ajuster au mieux les paramètres comme VREF, les résistances de gain ou la dynamique de l'amplificateur 161.

Les lots de GMR présents sur chaque barrette 100 peuvent dans certains cas montrer une dispersion beaucoup trop importante pour trouver une valeur de compensation moyenne pour chacune des voies.

Dans ce cas, on peut alors étendre le principe en introduisant une masse flottante où le signal de sortie AMPLIi ne sera plus référencé par rapport à la masse commune des modules, mais à une masse flottante déterminée par le point milieu des ponts de mesure (type ponts de Wheatstone) 163 dans lesquels entrent les cellules GMR, telles que celles des figures 4 et 5, ou par un autre point de polarisation que le point milieu, ce dernier permettant toutefois une réalisation particulièrement simple.

Ce mode de réalisation est illustré sur la figure 13. Le sens et la valeur du décalage ne sont alors plus trop contraignants.

Un aspect innovant de ce mode de fonctionnement permet de mesurer les variations de GMR indépendamment du sens du champ rencontré. Cela permet de s'affranchir du positionnement dans lequel s'orientent les GMR à leur implantation, mais également de la tension effectivement appliquée sur la cellule de pile.

On sait que la présence de tensions négatives sur les cellules de pile apparaît pendant certaines phases de fonctionnement de la pile, en particulier lors du démarrage de la pile à combustible (alimentation en réactifs), que l'on rencontre souvent dans les applications automobiles.

La valeur de compensation COMPi est fixée à VREF/2 puisque les résistances R2 et R'2 sont égales, VREF pouvant être une référence externe ou simplement la tension VCC d'alimentation des différents modules. En revanche, le gain est divisé par 2.

En prenant comme hypothèse un décalage (offset) compris entre - 60mV et +60mV et une dynamique comprise entre -80mV et +80mV, on arrive à une excursion du signal de pont comprise entre -140mV et +140mV. Si l'on considère que VREF=VCC=3,3V (tension commune aux technologies électroniques qui peuvent être retenues à titre d'exemple), l'excursion du signal amplifiée est égale à 1,65. On approche alors un gain de l'ordre de 10-12, mais celui-ci peut être plus élevé et par exemple être de l'ordre de 30.

Un autre aspect important de la présente invention concerne la miniaturisation des capteurs, et en particulier de la barrette 100 regroupant les 8 voies.

L'intégration sous forme de système hybride encapsulé, ou SiP (System in Package), des différents composants présentés sur la figure 8 est une première étape de miniaturisation technologique. On utilise les techniques de conception en trois dimensions avec empilage de circuits imprimés, les échanges de signaux s'effectuant sur les tranches.

On procède ainsi à la réalisation d'un premier circuit imprimé contenant la barrette GMR 100 et les amplificateurs d'instrumentation 201 à 208. On effectue un regroupement des pistes de signaux sur les tranches. Le circuit imprimé découpé est inscrit dans un cadre doré.

On effectue ensuite la réalisation d'un deuxième circuit imprimé contenant les multiplexeurs 300 (tels que les modules U25 à U31 de la figure 11). Là encore, le regroupement des pistes de signaux est effectué sur les tranches. Le circuit imprimé découpé est également inscrit dans un cadre doré.

Ces deux circuits imprimés sont ensuite assemblés ; puis moulés et encapsulés. Les pistes des signaux sur tranches sont reliées ensuite aux broches d'entrées-sorties constituant le dispositif de liaison 401, 402 de la figure 8.

Une telle réalisation permet de disposer l'instrumentation au plus près de la barrette 100, minimisant les sources de bruit externes venant principalement de la connectique.

On dispose ainsi de systèmes hybrides encapsulés prêts à être associés à 8 cellules de pile (pour le cas considéré d'une barrette 100 à 8 cellules à GMR instrumentées).

Ce système hybride encapsulé peut bien sûr s'étendre au suivi de piles à combustibles ou tout autre générateur électrique contenant une pluralité de cellules.

En particulier, cela peut être appliqué à des piles pouvant comprendre par exemple 120 cellules dont il est nécessaire de connaître l'évolution au moins deux fois par seconde.

Les technologies utilisées pour la fabrication des barrettes de GMR s'apparentent à celles utilisées pour la fabrication de composants électroniques plus classiques. Il est donc possible de disposer, avec une dispersion acceptable de lots de barrettes et corrigible par une campagne d'étalonnage, la fabrication en petite série de systèmes hybrides ne présentant, pour la société spécialisée dans ce domaine, aucune difficulté majeure puisque les autres composants du SiP sont des composants discrets.

A titre d'exemple, une grappe de 15 systèmes hybrides a été conçue et implantée sur une carte support PCB pour couvrir les 120 voies d'une pile à combustible.

Une partie de l'électronique peut alors être mutualisée entre les différents systèmes en prenant en compte ces contraintes selon le schéma de principe de la figure 8.

Un module de traitement 400, qui assure les échanges de données avec les systèmes hybrides est représenté sur la figure 8 et comprend au moins :

une unité de traitement 405,
des entrées-sorties de type TOR 404,
des entrées analogiques,
des convertisseurs analogique-numérique 403,
éventuellement une unité de communication vers une entité distante, une communication au protocole CAN étant par exemple possible dans le cas d'une application automobile,
un circuit imprimé multicouche assurant l'ensemble des liaisons entre les systèmes hybrides et l'unité de traitement.

Le composant retenu pour l'implantation du système de traitement 400 peut par exemple disposer de deux convertisseurs analogiques numériques et assure la conversion quasi-simultanée d'un élément de chaque système hybride (soit 15 voies).

Le principe de fonctionnement simplifié est le suivant :

Sur sollicitation d'un triplet d'entrées-sorties <S1, S2, S3>,
Sélection d'un signal AMPLIi par barrette (donc d'une cellule GMR, donc d'une tension délivrée par une cellule de pile). Il y a donc 15 signaux présents sur les différents convertisseurs du composant.
Lecture et conversion analogique-numérique par le CA/N 403 des 15 signaux présents ;
Stockage des valeurs converties ;
Application du logiciel de traitement sur l'ensemble des données ;
Formation de la trame regroupant les 120 valeurs lues et traitées ;

Envoi de la trame sur le bus CAN.

La dispersion contenue des ponts de résistances ou des lignes de courant de la barrette GMR peut se corriger en procédant à un étalonnage de chacune des voies.

Pour cela chaque cellule est émulée par une source de tension de référence dans une gamme de tension spécifiée (typiquement de -1,2 à + 1,2V). La réponse des GMR étant quasi-linéaire, en théorie deux points de calibration par cellule GMR suffisent, pris aux extrémités de la gamme de mesure de tension.

En pratique, compte tenu des dispersions mais surtout des décalages à l'origine, sept points ont été utilisés. Cela a permis d'affiner la linéarité des points de mesure observés et d'éliminer les zones non linéaires (saturation).

On peut également optimiser en intégrant les faibles dispersions liées à la température dans la gamme de -20°C à 80°C.

En considérant que les GMR travaillent dans leur zone linéaire, l'étalonnage consiste en la mesure de plusieurs couples <tension appliquée à la cellule GMR VCELL, valeur binaire convertie par le convertisseur analogique/numérique VBIN >.

Par extrapolation linéaire, on calcule les coefficients Ai et Bi correspondant à ces mesures.

L'équation peut s'écrire : VCELLi = AI*VBINI+Bi, VCELLI étant appelée valeur de tension reconstituée.

Un tableau regroupant les 120 coefficients Ai et Bi est constitué. Il est ensuite écrit dans le logiciel de traitement, soit recopié dans un fichier externe lu par le logiciel de traitement.

Le logiciel de traitement effectue ce calcul et délivre donc des tensions de cellule de pile reconstituées. En fonction de l'application visée, d'autres traitements peuvent être appliqués sur ces données reconstituées (moyennage, seuillage, .....) permettant un diagnostic sur l'état des cellules et un suivi pour la mesure de leur vieillissement.

Ces différents traitements peuvent déboucher sur la génération de différentes trames de résultats (données état des cellules, tensions reconstituées, ...) qui sont ensuite émises à partir des ports CAN vers le contrôle-commande véhicule.

L'application présentée ci-dessus permet la mesure de tension issue de piles à combustible comprise entre 0 et +1,2V tout en permettant la lecture de tension négative.

La lecture de tension de cellules plus élevée, comme par exemple les tensions de cellules de batterie, autour de 3,6V voire plus (6V), n'est pas directement possible à l'aide de ces systèmes hybrides, la technologie retenue pour la cellule GMR ne le permettant pas sans risque majeur de vieillissement accéléré, voire de destruction.

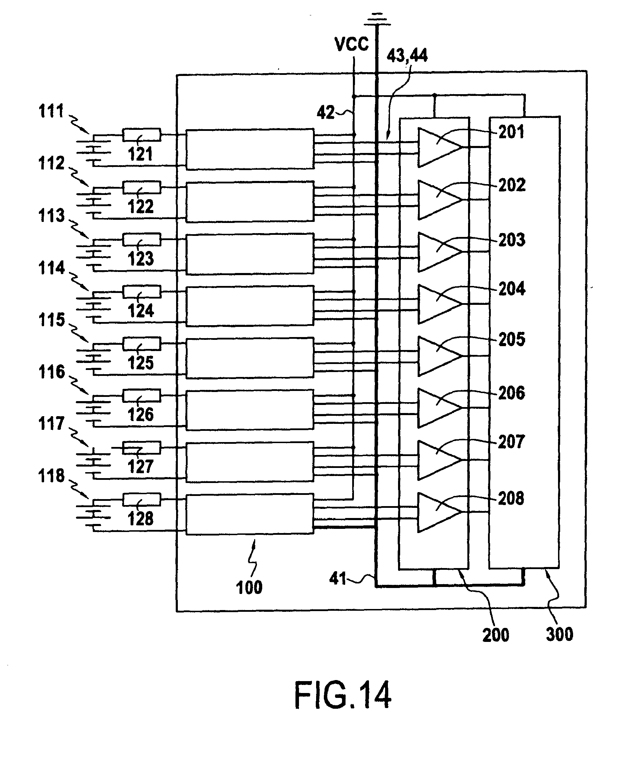

Une approche simple et fonctionnelle peut être appliquée au système hybride pour répondre à ces niveaux de tension. Une résistance adaptée 121 à 128 est insérée entre les points de mesure de la tension pile et les entrées correspondantes du système hybride comme le montre la figure 14. Elle fait diviseur résistif avec la résistance de la ligne de courant. Le choix de cette résistance du pont d'entrée est bien sûr adapté à la gamme de mesure délivrée par les cellules de pile ou de batterie. En tout état de cause, la sélection de la résistance tiendra compte de la résistance de la ligne (définie à partir du courant dérivé maximum de 20mA sous 1,2V, soit autour de 50 Ohms), de la sensibilité globale attendue pour le système hybride et d'une dissipation thermique qu'elle va créer (en dehors de la puce toutefois).

On peut naturellement également redéfinir la ligne de courant en l'adaptant aux tensions mesurées, mais cela sous-entend de réaliser des composants SIP dédiés à des plages de mesures de tension et il sera nécessaire de prendre en considération dans la conception du composant la dissipation thermique globale interne à la puce dans ce contexte. Le mode de réalisation de la figure 14 permet au contraire de conserver les mêmes modules hybrides de base et de les adapter facilement à des niveaux de tension de pile plus élevés.

Le développement de capteurs de courant à base de magnétorésistances GMR permet d'envisager des solutions très intégrées et présentant une résolution inégalée. L'isolation galvanique intégrée qui permet d'atteindre des résolutions de 10 μA alors que les réalisations connues se situent dans le domaine du mA ou même de 10mA et la fonction d'auto-fusible sont des caractéristiques avantageuses pouvant être mises en oeuvre avec la présente invention.

Enfin l'intégration dans un même module de la partie amplification, de plusieurs voies partageant un multiplexage avec un décodage d'adresse est aussi une amélioration importante par rapport aux systèmes existants.

La technologie GMR, telle que conditionnée dans le cadre de la présente invention, présente notamment les intérêts suivants, en plus de tous ceux qui ont déjà été énumérés plus haut en référence à la technologie GMR et TMR :

- carte de mesure de tension permettant la surveillance du système de pile à combustible (PAC) et l'optimisation et la sécurisation du contrôle commande du système PAC,
- système permettant de doter la pile d'un capteur intelligent accessible par l'ensemble des calculateurs à travers un réseau CAN pour l'application automobile visée comme application importante de la présente invention,
- Modularité des composants électroniques GMR (1 SiP GMR comprend 8 ponts (cellules) GMR assurant la mesure de 8 tensions).

**Revendications**

**1.** Capteur intégré de mesure de tension via un courant ou de mesure de courant à base de magnétorésistances, comprenant des première et deuxième bornes (1, 2) de connexion à un générateur dont la tension ou le courant est à mesurer, reliées à une ligne de mesure (4, 5) métallique dans laquelle circule un courant proportionnel à la tension ou au courant du générateur qui est à mesurer, et au moins deux magnétorésistances (31, 32, 33, 34) de mesure du champ magnétique créé à distance par ledit courant circulant dans ladite ligne de mesure (4, 5), la ligne de mesure métallique comprend au moins des premier et deuxième tronçons (4, 5) allongés et parallèles dans lesquels le courant circule en sens opposés, reliés à une portion (3) destinée à fermer la ligne de mesure, l'ensemble de la ligne de mesure métallique (3, 4, 5) étant disposée sur l'une des faces d'une couche d'isolation galvanique intégrée (8) **caractérisé en ce que** présente une épaisseur comprise entre 5 et 15 micromètres pour assurer une isolation galvanique pour des tensions supérieures ou égales à 1500 V, ladite couche d'isolation galvanique intégrée (8) étant elle-même disposée sur une portion de circuit intégré de détection, ladite portion de circuit intégré de détection comprenant lesdites au moins deux magnétorésistances (31, 32, 33, 34) qui présentent elles-mêmes chacune une partie sensible qui est essentiellement superposée à l'un des tronçons allongés (4, 5) de la ligne de mesure métallique afin d'être sensible au champ créé par le courant circulant dans la ligne de mesure, et **en ce que** chacun des premier et deuxième tronçons allongés (4, 5) de la ligne de mesure métallique comprend un rétrécissement (6, 7) dans une zone voisine d'une zone superposée à une piste (51) de liaison à un contact de masse (41), du côté desdites première et deuxième bornes (1, 2), lesdits rétrécissements (6, 7) servant de fusible intégré en cas de défaut d'isolation créé par un pic de surtension.

**2.** Capteur intégré selon la revendication 1, **caractérisé en ce que** l'ensemble de la ligne de mesure métallique (3, 4, 5) est directement déposé sur l'une des faces de la couche d'isolation galvanique intégrée (8), et en vis-à-vis avec la partie sensible des magnétorésistances déposées directement sur l'autre face de cette couche d'isolation galvanique intégrée (8), de sorte que seule l'épaisseur de cette couche d'isolation sépare la ligne de mesure de ladite partie sensible.

**3.** Capteur intégré selon l'une quelconque des revendications 1 à 2, **caractérisé en ce que** ladite portion de circuit intégré de détection comprend un pont (30) de magnétorésistances et des pistes de liaison à au moins un contact de polarisation en tension Vcc (42), un contact de masse (41) et des contacts (43, 44) de pôles négatif Vin- et positif Vin+ d'une tension différentielle de sortie.

**4.** Capteur intégré selon la revendication 1 ou la revendication 3, **caractérisé en ce que** les magnétorésistances (31, 32, 33, 34) présentent chacune la forme d'un C avec une branche centrale longitudinale qui constitue ladite partie sensible qui est essentiellement superposée à l'un des tronçons allongés (4, 5) de la ligne de mesure métallique afin d'être sensible au champ créé par le courant circulant dans la ligne de mesure.

**5.** Capteur intégré selon la revendication 1 ou 2, **caractérisé en ce que** les magnétorésistances sont des magnétorésistances géantes (31, 32, 33, 34), chacune des magnétorésistances géantes présentant une longueur comprise entre 100 et 500 micromètres et une largeur comprise entre 2 et 8 micromètres.

**6.** Capteur intégré selon les revendications 1 ou 2, **caractérisé en ce que** les magnétorésistances sont des magnétorésistances tunnel (31, 32, 33, 34), présentant une couche libre (61 ; 62) en forme de C de longueur comprise entre 40 et 150 $\mu$m et une largeur comprise entre 2 et 8 $\mu$m et une couche dure formée d'un ou de deux plots (70 ; 71, 72) dont la taille est ajustée pour obtenir des résistances comprises entre 300 ohms et 10 kiloohms.

**7.** Capteur intégré selon l'une quelconque des revendications 1 à 6, **caractérisé en ce que** la ligne de mesure métallique (3, 4, 5) présente une résistance comprise entre 30 et 100 ohms.

**8.** Capteur intégré selon l'une quelconque des revendications 1 à 7, **caractérisé en ce que** les premier et deuxième tronçons allongés (4, 5) de la ligne de mesure métallique (3, 4, 5) présentent une largeur comparable à celle desdites parties sensibles des magnétorésistances (31, 32, 33, 34).

**9.** Capteur intégré selon l'une quelconque des revendications 1 à 8, **caractérisé en ce que** la couche d'isolation galvanique (8) est choisie parmi un dépôt de résine durcie comprenant un polyimide ou du bisbenzocyclotène (BCB) ou est constituée par un dépôt d'isolant céramique et comprend une couche de $Si_3N_4$ ou de $Al_2O_3$.

**10.** Système de diagnostic de mesure de tension ou de courant d'un générateur électrique, **caractérisé en ce qu'**il comprend au moins un module hybride de mesure comprenant une pluralité de capteurs de mesure de tension via un courant ou de mesure de courant à magnétorésistance géante (111 à 118) selon la revendication 5, intégrés sur une même barrette (100), un module (200) d'amplification comprenant une pluralité d'amplificateurs (201 à 208) recevant les signaux délivrés par ladite pluralité de capteurs (111 à 118), un module de multiplexage (300), un dispositif de liaison (401, 402) et un module séparé (400) de traitement numérique.

**11.** Système selon la revendication 10, **caractérisé en ce que** le module hybride de mesure comprend un premier circuit imprimé contenant ladite barrette (100) de capteurs et le module (200) d'amplification et un deuxième circuit imprimé contenant le module de multiplexage (300), des pistes d'échanges de signaux étant formées sur les tranches des circuits imprimés, et les premier et deuxième circuits imprimés étant assemblés, moulés et encapsulés avec des bornes de connexion d'entrée-sortie reliées auxdites pistes d'échange de signaux formées sur les tranches des circuits imprimés et connectées audit dispositif de liaison (401,402).

**12.** Système selon la revendication 10 ou la revendication 11, **caractérisé en ce que** chaque capteur intégré de mesure de tension ou de courant à magnétorésistance géante comprend des première et deuxième bornes (1, 2) de connexion à une cellule individuelle du générateur dont la tension ou le courant est à mesurer et une ligne de mesure (4, 5) métallique, la ligne de mesure métallique comprenant des premier et deuxième tronçons (4, 5) allongés et parallèles dans lesquels le courant circule en sens opposés, reliés à une portion (3) destinée à fermer la ligne de mesure, l'ensemble de la ligne de mesure métallique (3, 4, 5) étant disposée sur une couche d'isolation galvanique (8), elle-même disposée sur une portion de circuit intégré comprenant un pont (30) de magnétorésistances géantes et des pistes de liaison à au moins un contact de polarisation e tension Vcc (42), un contact de masse (41) et des contacts (43, 44) de pôles négatif Vin-et positif Vin+ d'une tension différentielle de sortie, les magnétorésistances géantes (31, 32, 33, 34) présentant elles-mêmes la forme d'un C avec une branche centrale longitudinale constituant une partie sensible de la magnétorésistance qui est essentiellement superposée à l'un des tronçons allongés (4, 5) de la ligne de mesure métallique.

**13.** système selon l'une quelconque des revendications 10 à 12, **caractérisé en ce qu'**il comprend en outre une résistance (121 à 128) disposée entre un point de mesure de chaque cellule du générateur électrique et la borne d'entrée correspondante de la barrette (100) de capteurs.

**14.** système selon l'une quelconque des revendications 10 à 13, **caractérisé en ce que** chaque barrette (100) comprend huit capteurs (111 à 118) de mesure de tension ou de courant à magnétorésistance géante, le module (200) d'amplification comprend également huit amplificateurs (201 à 208) et le module (300) de multiplexage comprend au moins trois étages avec sept cellules élémentaires de multiplexage activées par trois signaux de sélection (SI, S2, S3).

**Patentansprüche**

**1.** Integrierter Sensor zum Messen einer Spannung über einen Strom oder Strommessung auf der Grundlage von Magnetowiderständen, der erste und zweite Klemmen (1, 2) zum Verbinden mit einem Generator aufweist, dessen Spannung oder Strom zu messen ist, die mit einer metallischen Messleitung (4, 5) verbunden sind, in der ein Strom zirkuliert, der zur Spannung oder zum Strom des Generators, der zu messen ist, proportional ist, und mindestens zwei Magnetowiderstände (31, 32, 33, 34) zum Messen des Magnetfelds, das in Entfernung von dem Strom, der in der Messleitung (4, 5) zirkuliert, geschaffen wird,

wobei die metallischen Messleitung mindestens langgestreckte und parallele erste und zweite Abschnitte (4, 5) aufweist, in welchen der Strom in entgegengesetzte Richtungen fließt, die mit einem Abschnitt (3) verbunden sind, der dazu bestimmt ist, die Messleitung zu schließen, wobei die gesamte metallischen Messleitung (3, 4, 5) auf einer der Seiten einer integrierten galvanischen Isolationsschicht (8) angeordnet ist, **dadurch gekennzeichnet, dass** die Schicht eine Stärke zwischen 5 und 15 Mikrometer aufweist, um eine galvanische Isolation für Spannungen größer oder gleich 1500 V sicherzustellen, wobei die integrierte galvanische Isolationsschicht (8) selbst auf einem Abschnitt einer integrierten Erfassungsschaltung angeordnet ist, wobei der Abschnitt integrierte Erfassungsschaltung die mindestens zwei Magnetowiderstände (31, 32, 33, 34) aufweist, die selbst jeweils einen sensiblen Teil aufweisen, der im Wesentlichen einem der langgestreckten Abschnitt (4, 5) der metallischen Messleitung überlagert ist, um für das Feld sensibel zu sein, das von dem Strom geschaffen wird, der in der Messleitung zirkuliert, und dass der erste und der zweite langgestreckte Abschnitt (4, 5) der metallischen Messleitung eine Verjüngung (6, 7) in einer Zone benachbart zu einer Zone, die einer Verbindungsleiterbahn (51) mit einem Massekontakt (41) auf der Seite der ersten und zweiten Klemme (1, 2) überlagert ist, aufweist, wobei die Verjüngungen (6, 7) als integrierte Sicherung für den Fall eines Isolationsmangels, der durch eine Überspannungsspitze entsteht, dienen.

2. Integrierter Sensor nach Anspruch 1, **dadurch gekennzeichnet, dass** die Einheit der metallischen Messleitung (3, 4, 5) direkt auf einer der Seiten der integrierten galvanischen Isolationsschicht (8) und gegenüber dem sensiblen Teil der Magnetowiderstände angeordnet ist, die direkt auf der anderen Seite dieser integrierten galvanischen Isolationsschicht (8) aufgebracht sind, so dass nur die Stärke dieser Isolationsschicht die Messleitung von dem sensiblen Teil trennt.

3. Integrierter Sensor nach einem der Ansprüche 1 bis 2, **dadurch gekennzeichnet, dass** der Abschnitt integrierte Erfassungsleitung eine Brücke (30) aus Magnetowiderständen und Verbindungsleiterbahnen mit mindestens einem Vcc Spannungspolarisationskontakt (42), einem Massekontakt (41) und Kontakten (43, 44) negativer Vin- und positiver Vin+ Pole einer Ausgangsdifferenzspannung aufweist.

4. Integrierter Sensor nach Anspruch 1 oder 3, **dadurch gekennzeichnet, dass** die Magnetowiderstände (31, 32, 33, 34) jeweils die Form eines C aufweisen, mit einem zentralen Längsschenkel, der den sensiblen Teil bildet, der im Wesentlichen einem der langgestreckten Abschnitte (4, 5) der metallischen Messleitung überlagert ist, um für das Feld sensibel zu sein, das von dem Strom, der in der Messleitung zirkuliert, geschaffen wird.

5. Integrierter Sensor nach Anspruch 1 oder 2, **dadurch gekennzeichnet, dass** die Magnetowiderstände Riesen-Magnetowiderstände (31, 32, 33, 34) sind, wobei jeder dieser Riesen-Magnetowiderstände eine Länge zwischen 100 und 500 Mikrometer und eine Breite zwischen 2 und 8 Mikrometer aufweist.

6. Integrierter Sensor nach den Ansprüchen 1 oder 2, **dadurch gekennzeichnet, dass** sie die Magnetowiderstände Tunnel-Magnetowiderstände (31, 32, 33, 34) sind, die eine freie Schicht (61; 62) in C-Form mit einer Länge zwischen 40 und 150 $\mu$m und einer Breite zwischen 2 und 8 $\mu$m sowie eine harte Schicht, die aus einem oder mehreren Klötzen (70; 71, 72) ausgebildet ist, deren Größe angepasst ist, um Widerstände zwischen 300 Ohm und 10 kOhm zu erzielen, aufweisen.

7. Integrierter Sensor nach einem der Ansprüche 1 bis 6, **dadurch gekennzeichnet, dass** die metallische Messleitung (3, 4, 5) einen Widerstand zwischen 30 und 100 Ohm aufweist.

8. Integrierter Sensor nach einem der Ansprüche 1 bis 7, **dadurch gekennzeichnet, dass** der erste und der zweite langgestreckte Abschnitt (4, 5) der metallischen Messleitung (3, 4, 5) eine Breite aufweisen, die mit der der sensiblen Teile der Magnetowiderstände (31, 32, 33, 34) vergleichbar ist.

9. Integrierter Sensor nach einem der Ansprüche 1 bis 8, **dadurch gekennzeichnet, dass** die galvanische Isolationsschicht (8) aus einer Ablagerung aus gehärtetem Harz, die ein Polyimid oder Bisbenzocycloten (BCB) aufweist, oder aus einer Ablagerung aus keramischem Isolationsmaterial besteht und eine Schicht aus $Si_3N_4$ oder $Al_2O_3$ aufweist.

10. Diagnosesystem zur Spannungs- oder Strommessung eines elektrischen Generators, **dadurch gekennzeichnet, dass** es mindestens ein hybrides Messmodul aufweist, das eine Mehrzahl von Spannungsmesssensoren über einen Strom oder Strommessung mit Riesen-Magnetowiderstand (111 bis 118) nach Anspruch 5 aufweist, die auf ein und demselben Steg (100) angeordnet sind, wobei ein Verstärkungsmodul (200) eine Mehrzahl von Verstärkern (201 bis 208) aufweist, die Signale empfangen, die von der Mehrzahl von Sensoren (111 bis 118) geliefert werden, ein Multiplexmodul (300), eine Verbindungsvorrichtung (401, 402) und ein getrenntes Modul (400) zur digitalen Verarbeitung.

**11.** System nach Anspruch 10, **dadurch gekennzeichnet, dass** das Hybridmodul eine erste Schaltung aufweist, die den Steg (100) mit Sensoren und das Verstärkungsmodul (200) aufweist, und eine zweite Schaltung, die das Multiplexmodul (300) aufweist, wobei Leiterbahnen zum Austauschen von Signalen auf den Gräben der Schaltungen ausgebildet sind, und wobei die erste und die zweite Schaltung zusammengefügt, geformt und mit Eingangs- Ausgangs-Klemmen, die mit den Leiterbahnen zum Austauschen von Signalen, die auf den Gräben der Schaltungen ausgebildet sind, gekapselt und mit der Verbindungsvorrichtung (401, 402) verbunden sind.

**12.** System nach Anspruch 10 oder 11, **dadurch gekennzeichnet, dass** jeder integrierte Sensor zur Spannungs- oder Strommessung mit Riesen-Magnetowiderstand eine erste und zweite Klemme (1, 2) zum Verbinden mit einer einzelnen Zelle des Generators, dessen Spannung oder Strom zu messen ist, sowie eine metallische Messleitung (4, 5) aufweist, wobei die metallische Messleitung einen langgestreckten und parallelen ersten und einen zweiten Abschnitt (4, 5), in welchen der Strom in entgegengesetzte Richtungen zirkuliert, aufweist, die mit einem Abschnitt (3) verbunden sind, der dazu bestimmt ist, die Messleitung zu schließen, wobei die gesamte metallische Messleitung (3, 4, 5) auf einer galvanischen Isolationsschicht (8) angeordnet ist, die selbst auf einem Schaltungsabschnitt angeordnet ist, der eine Brücke (30) aus Riesen-Magnetowiderständen und Leiterbahnen zum Verbinden mit mindestens einem Vcc Spannungspolarisationskontakt (42), einem Massekontakt (41) und Kontakten (43, 44) mit negativem Pol Vin- und positivem Pol Vin+ mit einer Differenzausgangsspannung aufweist, wobei die Riesen-Magnetowiderstände (31, 32, 33, 34) selbst die Form eines C mit einem zentralen Längsschenkel aufweisen, der einen sensiblen Teil des Magnetowiderstands bildet, der im Wesentlichen einem der langgestreckten Abschnitte (4, 5) der metallischen Messleitung überlagert ist.

**13.** System nach einem der Ansprüche 10 bis 12, **dadurch gekennzeichnet, dass** es ferner einen Widerstand (121 bis 128) aufweist, der zwischen einer Messstelle jeder Zelle des elektrischen Generators und der entsprechenden Eingangsklemme des Stegs (100) aus Sensoren angeordnet ist.

**14.** System nach einem der Ansprüche 10 bis 13, **dadurch gekennzeichnet, dass** jeder Steg (100) acht Sensoren (111 bis 118) zum Spannungs- oder Strommessen mit Riesen-Magnetowiderstand aufweist, das Verstärkungsmodul (200) ebenfalls acht Verstärker (201 bis 208) aufweist, und das Multiplexmodul (300) mindestens drei Stufen mit sieben Elementar-Multiplexzellen, die von drei Auswahlsignalen (S1, S2, S3) aktiviert werden, aufweist.

## Claims

**1.** An integrated sensor for measuring voltage via a current or for measuring current based on magnetoresistors, including first and second terminals (1, 2) for connection to a generator, the voltage or current of which is to be measured, connected to a metallic measuring line (4, 5) in which circulates a current proportional to the voltage or current of the generator which is to be measured, and at least two magnetoresistors (31, 32, 33, 34) for measuring the magnetic field created remotely by the said current circulating in the said measuring line (4, 5), the metallic measuring line includes at least first and second elongated and parallel sections (4, 5) in which the current circulates in opposite directions, connected to a portion (3) intended to close the measuring line, the assembly of the metallic measuring line (3, 4, 5) being arranged on one of the faces of an integrated galvanic isolation layer (8), **characterized in that** the said layer has a thickness comprised between 5 and 15 micrometres to provide a galvanic isolation for voltages greater than or equal to 1500 V, the said integrated galvanic isolation layer (8) being itself arranged on a portion of the integrated detection circuit, the said portion of the integrated detection circuit including the said at least two magnetoresistors (31, 32, 33, 34) which themselves each have a sensitive part which is essentially superimposed on one of the elongated sections (4, 5) of the metallic measuring line so as to be sensitive to the field created by the current circulating in the measuring line, and **in that** each of the first and second elongated sections (4, 5) of the metallic measuring line includes a constriction (6, 7) in a zone adjacent to a zone superimposed on a connecting path (51) to a ground contact (41), on the side of the said first and second terminals (1, 2), the said constrictions (6, 7) serving as an integrated fuse in the case of an isolation defect created by an overvoltage peak.

**2.** The integrated sensor according to claim 1, **characterized in that** the assembly of the metallic measuring line (3, 4, 5) is arranged directly on one of the faces of the integrated galvanic isolation layer (8), and opposite the sensitive part of the magnetoresistors arranged directly on the other face of this integrated galvanic isolation layer (8), such that only the thickness of this isolation layer separates the measuring line from the said sensitive part.

3. The integrated sensor according to any one of claims 1 to 2, **characterized in that** the said portion of integrated detection circuit includes a bridge (30) of magnetoresistors and of connecting paths to at least one Vdc voltage polarisation contact (42), a ground contact (41) and negative Vin- and positive Vin+ pole contacts (43, 44) of a differential output voltage.

4. The integrated sensor according to claim 1 or 3, **characterized in that** the magnetoresistors (31, 32, 33, 34) each have a C shape with a central longitudinal branch which constitutes the said sensitive part which is essentially superimposed on one of the elongated sections (4, 5) of the metallic measuring line so as to be sensitive to the field created by the current circulating in the measuring line.

5. The integrated sensor according to claim 1 or 2, **characterized in that** the magnetoresistors are giant magnetoresistors (31, 32, 33, 34), each of the giant magnetoresistors having a length comprised between 100 and 500 micrometres and a width comprised between 2 and 8 micrometres.

6. The integrated sensor according to claims 1 or 2, **characterized in that** the magnetoresistors are tunnel magnetoresistors (31, 32, 33, 34), having a free layer (61; 62) in the shape of a C with a length comprised between 40 and 150 $\mu$m and a width comprised between 2 and 8 $\mu$m and a hard layer formed by one or two posts (70; 71, 72), the size of which is adjusted to obtain resistances comprised between 300 ohm and 10 kiloohm.

7. The integrated sensor according to any one of claims 1 to 6, **characterized in that** the metallic measuring line (3, 4, 5) has a resistance comprised between 30 and 100 ohm.

8. The integrated sensor according to any one of claims 1 to 7, **characterized in that** the first and second elongated sections (4, 5) of the metallic measuring line (3, 4, 5) have a width comparable with that of the said sensitive parts of the magnetoresistors (31, 32, 33, 34).

9. The integrated sensor according to any one of claims 1 to 8, **characterized in that** the galvanic isolation layer (8) is selected from a hardened resin deposit including a polyimide or bisbenzocylcotene (BCB) or is constituted by a deposit of ceramic insulating material and includes a layer of $Si_3N_4$ or of $Al_2O_3$.

10. A voltage or current measurement diagnostic system of an electric generator, **characterized in that** it includes at least one hybrid measurement module including a plurality of giant magnetoresistor sensors for measuring voltage via a current or for measuring current (111 to 118) according to claim 5, integrated on the same strip (100), an amplification module (200) including a plurality of amplifiers (201 to 208) receiving the signals delivered by the said plurality of sensors (111 to 118), a multiplexing module (300), a connecting device (401, 402) and a separate digital processing module (400).

11. The system according to claim 10, **characterized in that** the hybrid measurement module includes a first printed circuit containing the said strip (100) of sensors and the amplification module (200) and a second printed circuit containing the multiplexing module (300), signal exchange paths being formed on the sections of the printed circuits, and the first and second printed circuits being assembled, moulded and encapsulated with input-output connection terminals connected to the said signal exchange paths formed on the sections of the printed circuits and connected to the said connecting device (401, 402).

12. The system according to claim 10 or 11, **characterized in that** each integrated giant magnetoresistor sensor for measuring voltage or current includes first and second terminals (1, 2) for connection to an individual cell of the generator, the voltage or the current of which is to be measured, and a metallic measuring line (4, 5), the metallic measuring line including first and second elongated and parallel sections (4, 5) in which the current circulates in opposite directions, connected to a portion (3) intended to close the measuring line, the assembly of the metallic measuring line (3, 4, 5) being arranged on a galvanic isolation layer (8), itself arranged on a portion of integrated circuit including a bridge (30) of giant magnetoresistors and connecting paths to at least one Vdc voltage polarisation contact (42), a ground contact (41) and negative Vin- and positive Vin+ pole contacts (43, 44) of a differential output voltage, the giant magnetoresistors (31, 32, 33, 34) themselves having the shape of a C with a central longitudinal branch constituting a sensitive part of the magnetoresistor which is essentially superimposed on one of the elongated sections (4, 5) of the metallic measuring line.

13. The system according to any one of claims 10 to 12, **characterized in that** it further includes a resistor (121 to 128) arranged between a measuring point of each cell of the electric generator and the corresponding input terminal of the strip (100) of sensors.

14. The system according to any one of claims 10 to 13, **characterized in that** each strip (100) includes eight giant magnetoresistor sensors (111 to 118) for measuring voltage or current, the amplification module (200) also includes eight amplifiers (201 to 208) and the multiplexing module (300) includes at least three stages with seven elementary multiplexing cells activated by three selection signals (S1, S2, S3).

**FIG.1**

H (mT)

**FIG.2**

61

70    63

FIG.3A

62

71    64

72

63

FIG.3B

FIG.4

FIG.5

FIG.6

111 112 113 114 115 116 117 118

**FIG.7**

EP 2 598 896 B1

FIG.8

**FIG.9**

**FIG.10**

FIG.11

EP 2 598 896 B1

**FIG.12**

**FIG.13**

FIG.14

**EP 2 598 896 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2934419 A1
- US 20050110464 A
- WO 2006136577 A1
- WO 2007148028 A

**Littérature non-brevet citée dans la description**

- **PANNETIER-LECOEUR, M ; FERMON, C ; DE VIS-MES, A et al.** *JOURNAL OF MAGNETISM AND MAGNETIC MATERIALS,* 2007, vol. 316, E246-E248
- **PANNETIER-LECOEUR, M ; FERMON, C ; DE VIS-MES, A et al.** Low noise magnetoresistive sensors for current measurement and compasses. *JOURNAL OF MAGNETISM AND MAGNETIC MATERIALS,* 2007, vol. 316 (2), E246-E248